## Europäisches Patentamt
## European Patent Office
## Office européen des brevets

(19)

(11) Numéro de publication: **0 233 383**
**B1**

(12) ## FASCICULE DE BREVET EUROPEEN

(45) Date de publication du fascicule du brevet:
**14.03.90**

(51) Int. Cl.⁴: **G11C 8/00**, G11C 11/40

(21) Numéro de dépôt: **86202227.4**

(22) Date de dépôt: **10.12.86**

(54) **Circuit décodeur pour mémoire RAM statique.**

(30) Priorité: **17.12.85 FR 8518675**

(43) Date de publication de la demande:
**26.08.87 Bulletin 87/35**

(45) Mention de la délivrance du brevet:
**14.03.90 Bulletin 90/11**

(84) Etats contractants désignés:
**DE FR GB IT NL**

(56) Documents cités:
**EP-A- 0 140 413**

**GaAa IC SYMPOSIUM - TECHNICAL
DIGEST, 25-27 octobre 1983, Phoenix, Arizona,
pages 86-89, IEEE, New York, US; N. TOYODA et al.:
"A 256x4 BIT GaAs static ram"
IEEE TRANSACTIONS ON ELECTRON DEVICES, vol.
ED-29, no. 7, juillet 1982, pages 1110-1115, IEEE, New
York, US; G. BERT et al.: "High-speed GaAs static
random-access memory"**

(73) Titulaire: **LABORATOIRES D'ELECTRONIQUE PHILIPS,
3, Avenue Descartes, F-94450 Limeil-Brévannes(FR)**
(84) Etats contractants désignés: **FR**

(73) Titulaire: **N.V. Philips' Gloeilampenfabrieken,
Groenewoudseweg 1, NL-5621 BA Eindhoven(NL)**
(84) Etats contractants désignés: **DE GB IT NL**

(72) Inventeur: **Ducourant, Thierry Société Civile S.P.I.D.,
209 rue de l'Université, F-75007 Paris(FR)**
Inventeur: **Gabillard, Bertrand Société Civile S.P.I.D.,
209 rue de l'Université, F-75007 Paris(FR)**

(74) Mandataire: **Landousy, Christian et al, Société Civile
S.P.I.D. 209, Rue de l'Université, F-75007 Paris(FR)**

**Description**

L'invention concerne un circuit décodeur élémentaire pour une mémoire RAM statique intégrée monolithiquement, réalisé à l'aide de transistors à effet de champ en arséniure de gallium et constitué d'une porte NON-OU dont les $\underline{n}$ entrées reçoivent les $\underline{n}$ signaux codés d'addressage $a_1$, $a_2$...$a_n$ de la mémoire ou leurs complémentaires, dont la sortie fournit un signal appliqué sur le transistor haut d'un étage "push-pull", et un signal complémentaire, obtenu par l'intermédiaire d'un transistor inverseur, appliqué sur le transistor bas de l'étage "push-pull", le point commun des deux transistors de l'étage "push-pull" fournissant le signal de la ligne de mot de la mémoire.

Cette invention trouve son application dans la réalisation de mémoires-caches (en anglais : cache-memory) ultrarapides pour les gros ordinateurs utilisés dans les domaines de l'astrologie et de la météorologie, ainsi que pour les processeurs d'appareils de simulation de vol permettant la visualisation d'images numérisées à haute résolution.

Les circuits mémoires sont presque toujours organisés sous la forme d'un réseau de cellules qui présente la structure d'une matrice. Chaque cellule, correspondant à un chiffre binaire (en anglais BIT : BInary digiT) est située au croisement de deux lignes, une ligne horizontale ou rangée, une ligne verticale ou colonne. Ces lignes correspondant aux adresses de la mémoire et sont généralement notées $X_1$, $X_2$...$X_n$ pour les rangées et $Y_1$, $Y_2$...$Y_n$ pour les colonnes. Ainsi chaque cellule de la mémoire a une adresse unique et peut être sélectionnée en activant simultanément la rangée et la colonne appropriées. Après sélection de la cellule, la donnée peut être transmise à la cellule ou extraite de la cellule par une paire de lignes communes à toutes les cellules dites lignes de BIT (en anglais BIT-LINE).

Le nombre de lignes d'adresse nécessaire au fonctionnement d'une mémoire à structure matricielle est $2N^{1/2}$, où N est le nombre de points mémoire ou de BITS de mémoire. Un tel nombre de lignes d'adresse limiterait la taille de la mémoire, c'est pourquoi il est nécessaire d'avoit recours à un circuit décodeur qui réduit le nombre des lignes d'adresse. Pour une mémoire constituée de $2^n$ rangées et de $2P$ colonnes, dont la taille mémoire est donc N = $2^{(n+p)}$BITS, le circuit décodeur des adresses de rangée comportera $2^n$ circuits décodeurs élémentaires présentant chacun $\underline{n}$ entrées sur lesquelles sont appliquées les adresses $a_1$, $a_2$,... $a_n$ codées en binaire, tandis que le circuit décodeur des adresses de colonne comportera $2P$ circuits décodeurs élémentaires présentant chacun p entrées sur lesquelles sont appliquées les p adresses de colonnes $b_1$, $b_2$,... $b_n$ codées en binaire.

Chaque sortie de décodeur élémentaire, ou ligne de MOT, porte le signal binaire décodé réalisé selon l'une des $2^n$, ou bien $2P$ combinaisons logiques possibles desdites entrées.

On rappelle en outre que les mémoires dites RAM (de l'anglais : Random Access Memory : Mémoire à accès aléatoire) statiques se différentient des autres types de mémoire, d'une part, par le fait que les données peuvent y être à volonté lues ou inscrites, et d'autre part, par le fait que les données sont retenues en mémoire tant que l'alimentation et les signaux d'horloge externes, s'il y en a, sont maintenus. De ce fait, les signaux d'horloge externes ne sont pas obligatoires.

Pour la réalisation de mémoires-caches, destinées à l'application envisagée, la mise au point de mémoires RAM statiques ultrarapides, de faible consommation et monolithiquement intégrées, est impérative. C'est pourquoi, une technologie comprenant des transistors à effet de champ en arséniure de gallium est extrêmement favorable à la réalisation de tels circuits, du fait de la mobilité électronique particulièrement élevée dans ce matériau, permettant d'obtenir des temps de transit très courts dans les transistors. De plus, entre les différentes technologies actuellement réalisables à l'aide de transistors en arséniure de gallium, la technologie dite DC-FL (Direct Coupled Field-effect transistor Logic) est celle qui présente à la fois la plus faible consommation et la plus forte densité d'intégration alliées à une très grande rapidité. La porte logique élémentaire, ou inverseur, réalisée à l'aide de cette technologie, est composée d'un transistor à effet de champ à enrichissement (tension de pincement $V_T \gtrsim 0$) associé à une charge, et présente un signal de sortie compatible avec l'entrée de la porte logique suivante.

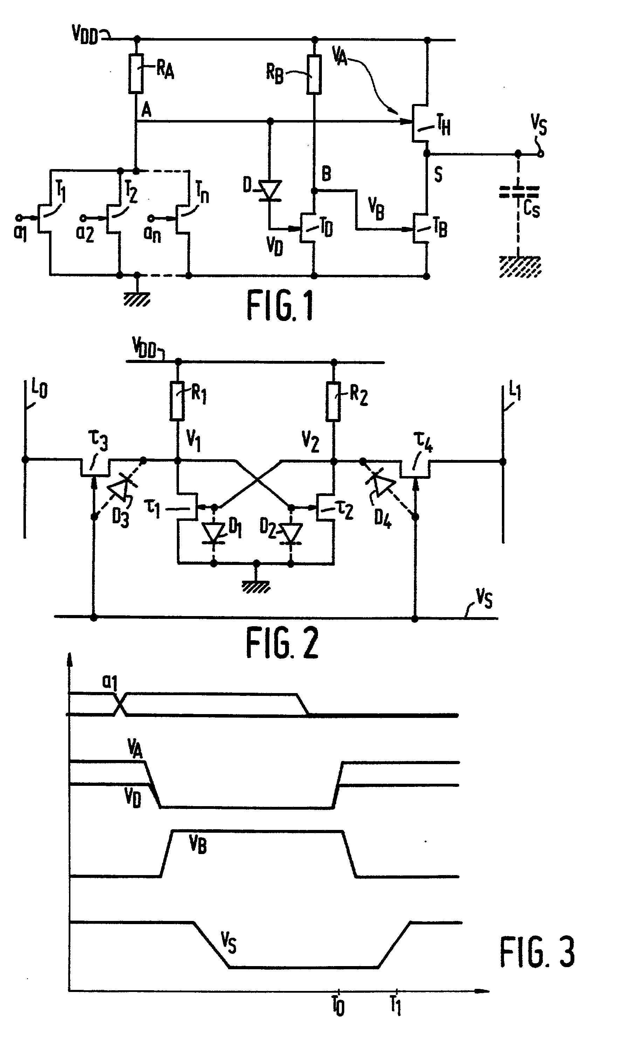

Or il est connu par la publication de M. INO et alii (Musashino Electrical communication Laboratory), dans le compte-rendu "IEEE GaAs I.C. Symposium 1982" sous le titre "GaAs 1Kb Static RAM with E/D MESFET DCFL", de réaliser un circuit décodeur pour une mémoire RAM statique, intégrée monolithiquement sur un substrat en arséniure de gallium (AsGa) et composée de transistors à effet de champ (MESFET : Metal Semiconductor Field Effect Transistor). Un circuit décodeur, tel que décrit dans le document cité et illustré par la figure 1 de la page 4 de ce même document, est composé de circuits décodeurs élémentaires. Chaque décodeur élémentaire est essentiellement constitué d'une porte NON-OU à $\underline{n}$ entrées, destinées à recevoir chacune une des entrées d'adresses codée en binaire, $a_1$, $a_2$,... $a_n$, exprimée sous la forme d'un signal vrai ou bien de son complémentaire, formé avant l'entrée dans le décodeur par un circuit intermédiaire (en anglais : ADDRESS BUFFER), de manière à obtenir sur la sortie de la porte NON-OU, une combinaison de ces chiffres binaires, produite par la fonction logique NON-OU et constituant l'adresse d'une ligne ou d'une colonne.

Cette porte NON-OU est formée de transistors à effet de champ en arséniure de gallium, à enrichissement, présentant une tension de pincement $V_T \gtrsim 0$, c'est-à-dire ne conduisant pas tant que la tension appliquée sur la grille n'est pas supérieure à cette tension $V_T$. Les transistors constituant cette porte NON-OU sont montés en parallèle, leur source commune étant reliée à la masse et leur drain commun étant relié aux grille-source court-circuitées d'un transistor à désertion, utilisé comme charge dite active.

Lorsque les valeurs du signal de sortie de la porte NON-OU passent de 0 à 1 ou de 1 à 0, la tension qui lui est associée charge ou décharge la capacité de sortie du circuit. Afin d'obtenir des temps équivalents pour la charge et la décharge de cette capacité, le signal de sortie de la porte NON-OU est porté sur l'entrée d'un étage inverseur de manière à pouvoir disposer à la fois du signal de sortie vrai et de son complémentaire, puis ces signaux sont appliqués respectivement chacun sur une des deux entrées d'un étage PUSH-PULL. L'étage inverseur utilisé comporte un transistor à enrichissement comme transistor inverseur et un transistor à désertion comme charge. L'étage PUSH-PULL comporte également un transistor à enrichissement, monté en source commune à la masse, en série avec un transistor à désertion monté en drain commun à la tension d'alimentation.

Or, dans l'état actuel de la technique de fabrication des circuits en arsénuire de gallium, le rendement de fabrication, c'est-à-dire le pourcentage de circuits fabriqués qui fonctionnent, est très faible : de l'ordre de 4 à 10 %. Après fabrication d'un circuit, ce dernier est testé et doit être éliminé s'il ne fonctionne pas. Ce mauvais rendement est dû aux difficultés rencontrées encore actuellement dans la mise en oeuvre de la technologie. C'est pourquoi, dans le but d'améliorer le rendement de fabrication d'un type de circuit, il est impératif de rendre ce type de circuit plus simple à réaliser.

Dans le cas du circuit décodeur, par exemple, il est intéressant de remplacer les transistors à désertion constituant les charges actives par des charges résistives, plus faciles à réaliser sur le plan technologique. D'autre part, il est intéressant de remplacer le transistor à désertion de l'étage PUSH-PULL par un transistor à enrichissement de manière à n'avoir recours qu'à un seul type de transistors pour la fabrication d'un tel circuit.

Mais si l'on envisage la transposition pure et simple du circuit décrit dans le document cité par la méthode décrite ci-dessus, on se heurte aussitôt au problème suivant : il apparaît entre la sortie de la porte NON-OU et la masse, une diode parasite due au fait que le transistor inverseur, sur lequel est portée cette tension de sortie, est du type Schottky. Cet effet de diode parasite empêche le signal de sortie de la porte NON-OU d'atteindre un niveau suffisant pour débloquer le transistor de l'étage PUSH-PULL sur lequel il est appliqué. L'étage PUSH-PULL est donc rendu inefficace, et dans ces conditions, il devient long et difficile de charger la capacité de sortie du décodeur élémentaire.

La présente invention permet de s'affranchir des inconvénients cités, au moyen d'un circuit tel que défini dans le préambule, en outre conforme à la partie caractérisante de la revendication 1.

Selon l'invention, le circuit décodeur présente alors, en autres avantages :
- d'être réalisé entièrement à l'aide de transistors d'un seul type dit à enrichissement, du fait que les deux transistors du push-pull sont de ce type, et avec une alimentation unique $V_{DD}$ ;
- d'être réalisé avec un nombre minimal d'éléments actifs. En effet le circuit selon l'invention permet de n'utiliser qu'une seule porte NON-OU à $\underline{n}$ entrées, tout en ayant la possibilité d'obtenir que le signal de sortie de cette porte atteigne une valeur suffisante pour polariser le transistor haut de l'étage push-pull avec une efficacité maximale. De plus les charges sont du type résistif.

L'invention sera mieux comprise grâce à la description détaillée du circuit illustrée par les figures ci-après annexées.

La figure 1 représente le circuit décodeur élémentaire selon l'invention.

La figure 2 représente le point mémoire de la mémoire RAM statique associée au circuit décodeur élémentaire selon l'invention.

La figure 3 représente le diagramme de propagation du signal $V_S$ sur la ligne de MOT par rapport au signal $a_i$ de sélection des adresses $a_1$, $a_2$,...$a_n$, en fonction du temps t, dans le circuit décodeur élémentaire selon l'invention.

Tel que représenté sur la figure 1, le circuit décodeur élémentaire, selon l'invention, comporte une porte NON-OU constituée de $\underline{n}$ transistors à effet de champ à enrichissement, $\underline{n}$ étant le nombre des signaux codés d'adressage de la mémoire. Sur les $\underline{n}$ entrées de cette porte NON-OU sont appliqués les $\underline{n}$ dits signaux codés d'adressage destinés à fournir la combinaison constituant l'adresse d'une ligne ou d'une colonne. Cette charge $R_A$ est reliée à la tension d'alimentation $V_{DD}$.

La charge de cette porte NON-OU est constituée par une résistance $R_A$ réalisée par implantation de matériaux dopants dans le substrat en GaAs. Les transistors de cette porte NON-OU sont montés en source commune reliée à la masse. La sortie $V_A$ de cette porte NON-OU se fait au noeud A, sur les drains de ces transistors reliés à la charge R.

Selon l'invention le signal $V_A$ est appliqué directement sur la grille du transistor haut $T_H$ d'un étage "push-pull". Ce transistor $T_H$ est du type à enrichissement. Son drain est porté au potentiel $V_{DD}$ et sa source S au drain du transistor bas $T_B$ du "push-pull",

Le point commun S des deux transistors du "push-pull" fournit la sortie $V_S$ du décodeur élémentaire, ou ligne de MOT.

Le transistor bas $T_B$ reçoit sur sa grille le signal $V_B$ complémentaire de la sortie $V_A$ de la porte NON-OU, par l'intermédiaire d'un étage inverseur formé du transistor à enrichissement $T_D$ chargé par la résistance $R_B$.

Comme il a été dit précédemment, si le signal $V_A$ est porté directement sur la grille du transistor inverseur comme montré dans le document cité comme état de la technique, alors le niveau des signaux fournis n'est pas suffisant pour polariser de façon correcte des transistors d'un étage "push-pull formé uniquement de transistors à enrichissement. Le circuit serait alors d'un fonctionnement très lent, ce qui doit être évité.

C'est pourquoi selon l'invention, le signal $V_A$ est porté à l'entrée de l'étage inverseur $T_D$ par l'intermédiaire d'une diode D.

Le circuit fonctionne alors de la façon suivante : Le signal de sortie $V_S$, en passant de 0 à 1, charge une capacité fictive $C_S$.

Lorsque toutes les entrées de la porte NON-OU sont à 0, la tension $V_A$, sur le noeud A, peut monter pratiquement jusqu'à la valeur de la tension $V_{DD}$. Le transistor $T_H$ sur la grille duquel cette tension $V_A$ est appliquée, devient conducteur. La capacité de sortie $C_S$ se charge par la tension $V_S$ qui devient alors très proche de la valeur $V_{DD}$ ; dans le même temps, le transistor $T_D$ de la porte inverseuse se trouve fortement polarisé et le pont B ramené à une valeur proche de la masse. Dans ces conditions, le transistor $T_D$ se trouve coupé et la capacité $C_S$ se charge avec un maximum d'efficacité.

Un des avantages dû à l'utilisation d'une diode de décalage consiste dans le fait que, possédant une capacité parallèle importante, cette dernière transmet pratiquement sans délai au point D, les fronts de montée et de descente observés au point A.

Au contraire, lorsque l'une des entrées de la porte NON-OU passe à 1, alors la valeur de la tension $V_A$ devient pratiquement nulle, puisque l'un des transistors sur lequel le signal "1" est appliqué devient conducteur. Une tension $V_A \simeq 0$ est donc appliqué sur la grille du transistor $T_H$ qui est alors bloqué. De la même manière, le transistor $T_D$ se trouve bloqué, et la résistance $R_B$, qui n'est plus désormais traversée par aucun courant, amène le potentiel $V_B$ proche de la tension de saturation de la diode grille-source du transistor bas de l'étage push-pull $T_B$. Celui-ci se trouve donc fortement conducteur et, déchargeant la capacité $C_S$, amène rapidement le potentiel $V_S$ à une valeur proche de $V_S = 0$.

Il est clair, que l'utilisation d'au moins une diode pour décaler les niveaux électriques permet de monter pratiquement à la valeur de l'alimentation positive $V_{DD}$ pourvu que la valeur de celle-ci soit exactement deux fois la valeur de la tension de décalage de la diode D qui est dans cet exemple avantageusement du type Schottky.

Pour une tension de décalage de l'ordre de 0,7 V pour la diode D, la valeur de la tension d'alimentation $V_{DD}$ sera choisie de l'ordre de 1,5 V.

Il faut noter que cette valeur, qui optimise le fonctionnement de l'invention, peut être utilisée pour tous les autres circuits de l'ensemble de la mémoire, laquelle fonctionne dès lors sous alimentation unique.

Dès lors, il n'est pas besoin d'insérer entre le noeud A du premier étage du décodeur élémentaire et le noeud B du second étage une capacité du type de la capacité 68, telle que décrite dans le brevet des Etats-Unis n° 38 63 230, pour polariser correctement le transistor $T_H$. En effet, la résistance $R_B$, reliée à la tension d'alimentation $V_{DD}$ = 1,5 Volt est alors tout à fait suffisante pour la bonne polarisation de ce transistor.

Il n'est pas non plus nécessaire d'utiliser comme dans la demande de brevet européen EP -0 140 413 une seconde porte NON-OU, qui double le nombre des transistors et donc la surface occupée par le circuit intégré, pour résoudre le problème du niveau des signaux qui sont reportés sur l'étage "push-pull".

Tel que représenté sur la figure 2, le "point mémoire" ou cellule mémoire est constitué de deux transistors $\tau_1$ et $\tau_2$ montés en bistable et alimentés à travers les résistances $R_1$ et $R_2$ respectivement par la tension d'alimentation $V_{DD}$. Du fait de l'existence de diodes fictives $D_1$ et $D_2$, entre les grilles respectives de ces transistors et la masse, dues au fait que les transistors $\tau_1$ et $\tau_2$ sont du type Schottky, les signaux $V_1$ et $V_2$, sur les drains de ces derniers transistors, sont écrêtés à la valeur de 0,7 Volt.

Dans ces conditions, il suffit que l'alimentation des "points mémoire" soit supérieure à 0,7 V pour assurer un fonctionnement correct de la mémoire.

La valeur $V_{DD}$ = 1,5 V, alimentation déjà utilisée dans la présente invention, constitue donc une valeur particulièrement avantageuse. Ainsi le niveau haut, ou "1" du signal $V_S$ (signal de sortie selon l'invention) n'a alors aucune valeur critique, puisqu'il se trouve automatiquement écrêté à 0,7 V par les diodes fictives $D_3$ et $D_4$ qui apparaissent entre la grille des transistors d'accès $\tau_3$ et $\tau_4$, de type Schottky et la masse (figure 2).

Le diagramme de propagation des signaux est représenté figure 2. La ligne de mot correspondant au point mémoire considéré n'est activée que dans le cas où toutes d'encombinaisons d'adresse $a_1$,...., $a_n$ présentes aux bornes d'entrée du circuit selon l'invention sont amenées à la valeur "0", ce qui correspond sur la figure 3 au temps $T_0$. Dès lors la tension de sortie $V_S$ monte à "1" au temps $T_1$. Le temps d'accès au point mémoire est alors :

$T_{accès} = T_1 - T_0$

Dans une réalisation du circuit selon l'invention, les résistances et les transistors présentent les caractéristiques suivantes :

Resistance $R_A$ = 3,5 k$\Omega$ , $R_B$ = 5,5 k$\Omega$

Longueur de grille des transistors 1 = 0,7 $\mu$m

Largeur des transistors de la porte NON-OU $\ell$ = 7 $\mu$m

Largeur des transistors $T_D$ et diode $D_1$ $\ell$ = 7 $\mu$m

Largeur du transistor $T_H$ $\ell$ = 20 $\mu$m

Largeur du transistor $T_B$ $\ell$ = 20 $\mu$m

Tension d'alimentation $V_{DD}$ = 1,5 V

Tension de pincement $V_T$ = 0,05 V

En outre, dans la réalisation de la cellule mémoire, les résistance et transistors présentent les caractéristiques suivantes :

Résistance de charge $R_1$ = $R_2$ = 100 k$\Omega$

Longueur de grille des transistors L = 0,7 $\mu$m

Largeur des transistors $\tau_1$ et $\tau_2$ $\ell$ = 7 $\mu$m

Largeur des transistors $\tau_3$ et $\tau_4$ $\ell$ = 3 $\mu$m

Tension de pincement $V_T$ = 0,05 V

Dans ces conditions un temps de propagation de 0,1 ns est obtenu dans le circuit décodeur élémentaire selon l'invention.

Dans une application à une mémoire RAM statique, le circuit décodeur de cette mémoire est composé de $2^n$ circuits décodeurs élémentaires identique réalisés selon l'invention pour activer les $2^n$ lignes de la mémoire, et de 2P circuits, décodeurs élémentaires identiques selon l'invention pour activer les 2P colonnes de la mémoire.

Il est manifeste que, d'une part l'application de l'invention aux mémoires-caches réalisées à l'aide de transistors à effet de champ intégrés sur un substrat d'arséniure de gallium, n'est pas limitative, et que d'autre part de nombreuses variantes sont possibles, en particulier sur la taille, les caractéristiques des transistors, sans sortir du cadre de la présente invention tel que défini par les revendications ci-après annexées.

## Revendications

1. Circuit décodeur élémentaire pour une mémoire RAM statique intégrée monolithiquement, réalisée à l'aide de transistors à effet de champ en arséniure de gallium et constituée d'une porte NON-OU (T1–Tn) dont les $\underline{n}$ entrées reçoivent les $\underline{n}$ signaux codés d'adressage ($a_1$, $a_2$,...$a_n$) de la mémoire, ou leurs complémentaires, dont la sortie (A) fournit un signal ($V_A$) appliqué sur le transistor haut ($T_H$) d'un étage PUSH-PULL, et un signal complémentaire ($V_B$), obtenu par l'intermédiaire d'un transistor inverseur ($T_D$), appliqué sur le transistor bas ($T_D$) de l'étage PUSH-PULL, le point commun (S) des deux transistors de l'étage PUSH-PULL fournissant le signal ($V_S$) de la ligne de MOT de la mémoire, caractérisé en ce que les deux transistors de l'étage PUSH-PULL sont, comme les transistors de la porte NON-OU du type dit "à enrichissement" et en ce que le signal de sortie de la porte NON-OU est appliqué sur l'entrée du transistor inverseur par l'intermédiaire d'une diode de décalage de niveau (D), de manière telle que la polarisation des transistors de l'étage PUSH-PULL produit la transmission extrêmement rapide des informations qui apparaîssent en sortie de la porte NON-OU, jusqu'à la ligne de MOT.

2. Circuit selon la revendication 1, caractérisé en ce que la charge ($R_A$) de la porte NON-OU, et la charge ($R_B$) du transistor inverseur sont du type résistif.

3. Circuit selon la revendication 1 ou 2, caractérisé en ce que la tension d'alimentation continue ($V_{DD}$) du circuit est le double de la tension de décalage de la diode.

4. Circuit décodeur pour une mémoire RAM statique, caractérisé en ce qu'il comprend $2^n$ décodeurs élémentaires identiques, selon l'une des revendications 1 à 3, pour activer les $2^n$ lignes de la mémoire, et en ce qu'il comprend 2P de ces décodeurs élémentaires identiques pour activer les 2P colonnes de la mémoire.

## Patentansprüche

1. Elementare Dekodierschaltung für einen monolithischen integrierten statischen Schreib-Lese-Speicher mit wahlfreiem Zugriff, die mit Hilfe von Galliumarsenid-Feldeffekttransistoren aufgebaut und durch ein NICHT-ODER-Gatter (T1–Tn) gebildet ist, dessen $\underline{n}$ Eingänge die $\underline{n}$ codierten Adressiersignale $a_1$, $a_2$, ..., $a_n$ des Speichers oder ihre Komplemente empfangen, wobei sein Ausgang (A) ein Signal ($V_A$) erzeugt, das an den oberen Transistor ($T_H$) einer Gegentaktstufe gelegt wird, und ein komplementäres Signal $V_B$, das über einen Umkehrtransistor erhalten ist, an den unteren Transistor ($T_D$) oder Gegentaktstufe gelegt wird, wobei der Knotenpunkt (S) der beiden Transistoren der Gegentaktstufe das Wortleitungssignal ($V_S$) des Speichers liefert, dadurch gekennzeichnet, daß die beiden Transistoren der Gegentaktstufe vom Verreicherungstyp sind wie auch die Transistoren des NICHT-ODER-Gatters, wobei das Ausgangssignal des NICHT-ODER-Gatters an den Eingang des Umkehrtransistors über eine Pegelverschiebungsdiode (D) gelegt wird, so daß die Polarisation der Transistoren der Gegentaktstufe die äußerst schnelle Datenübertragung vom Ausgang des NICHT-ODER-Gatters auf die Wortleitung ergibt.

2. Schaltung nach Anspruch 1, dadurch gekennzeichnet, daß die Belastung ($R_A$) des NICHT-ODER-Gatters und die Belastung ($R_B$) des Umkehrtransistors vom ohmischen Typ sind.

3. Schaltung nach Anspruch 1 oder 2, dadurch gekennzeichnet, daß die Gleichspannung ($V_{DD}$) der Schaltung das Zweifache der Verschiebespannung der Diode beträgt.

4. Dekodierschaltung für einen statischen Schreib-Lese-Speicher mit wahlfreiem Zugriff, dadurch gekennzeichnet, daß die Dekodierschaltung $2^n$ identische Elementardekodierer nach einem oder mehreren der Ansprüche 1 bis 3 zum Aktivieren der $2^n$ Zeiten des Speichers sowie (2P dieser identischen Elementardekodierer zum Aktivieren der 2P Spalten des Speichers enthält.

## Claims

1. An elementary decoder circuit for a monolithically integrated static RAM memory, the circuit being constructed by means of gallium arsenide field effect transistors and formed by a NOR-gate (T1–Tn) whose $\underline{n}$ inputs receive the $\underline{n}$ encoded addressing signals ($a_1$, $a_2$ ..., $a_n$) of the memory, or their complements, its output (A) supplying a signal ($V_A$) which is applied to the upper transistor ($T_H$) of a push-pull stage, as well as a complementary signal ($V_B$) which is obtained _via_ an inverter transistor ($T_D$) and which is applied to the lower transistor ($T_D$) of the push-pull stage, the junction point (S) of the two transistors of the push-pull stage supplying the word line signal ($V_S$) of the memory, characterized in that the two transistors of the push-pull stage are of the enhancement type, like the transistors of the NOR-gate, the output signal of the NOR-gate being applied to the input of the inverter transistor via a level shifting diode (D) so that the biasing of the transistors of the push-pull stage results in an extremely fast data transfer from the output of the NOR-gate to the word line.

2. A circuit as claimed in Claim 1, characterized in that the load ($R_A$) of the NOR-gate and the load ($R_B$) of the inverter transistor are of the resistive type.

3. A circuit as claimed in Claim 1 or 2, characterized in that the d.c. supply voltage ($V_{DD}$) of the circuit amounts to twice the shift voltage of the diode.

4. A decoder circuit for a static RAM memory, characterized in that it includes $2^n$ identical elementary decoders as claimed in any one of the Claims 1 to 3 for activating the $2^n$ memory rows, and also includes $2^p$ of such identical elementary decoders for activating the $2^p$ columns of the memory.

FIG.1

FIG.2

FIG. 3